# EUROPEAN PATENT SPECIFICATION

(11) **EP 0 370 639 B1**
(45) Date of publication and mention of the grant of the patent: **28.12.1994**
(21) Application number: 89311202.9
(22) Date of filing: 30.10.1989
(51) Int. Cl.: G01R 13/22, G09G 1/16, G01R 23/16

(54) **Signal analysis**
Signal-Analyse
Analyse de signal

(30) Priority: 03.11.1988 GB 8825748
(43) Date of publication of application: 30.05.1990
(73) Proprietor: ROLLS-ROYCE plc, London, SW1E 6AT (GB)
(72) Inventor: Brown, Ian David, Ashbourne Derbyshire (GB)
(74) Representative: Dargavel, Laurence Peter

(56) References cited:
- GB-A- 2 076 548
- GB-A- 2 142 174
- US-A- 3 634 760
- US-A- 4 464 656
- US-A- 4 672 308
- PATENT ABSTRACTS OF JAPAN, vol. 7, no. 220 (P-226)[1365], 30th September 1983;& JP-A-58 113 867 (NIPPON DENKI K.K.) 06-07-1983
- WIRELESS WORLD, vol. 86, no. 1533, May 1980, pages 55-60; P. HISCOCKS: "Audiospectrum analyser"
- ELEKTRONIK, vol. 29, no. 18, September 1980, pages 71-78, Munich, DE; H.-G.BERGANDT et al.: "Ein Fernsehoszilloskop mit modernen Bausteinen"
- IDEM
- IDEM
- ELEKTRONIK, vol. 28, no. 7, April 1979, pages 50-52; O. FEGER: "Darstellung vonBalkendiagrammen auf einem Fernsehbildschirm"

## Description

This invention relates to the reception of electromagnetic signals, in particular radio signals, and the discrimination between specific frequency components of such signals, e.g. to analyse the frequency spectrum of a signal.

Analysis of the frequency components in a radio signal may be required for a wide variety of purposes, one example being in the use of radio transmitters in telemetry and communications. Spectrum analysers are known which record the signal amplitude with respect to frequency but they are complex instruments. In order to identify accurately the signal strengths at specific frequencies as the frequency spectrum is swept it is necessary to ensure that the amplitude measurements are matched to their correct frequencies. In practice this depends upon maintaining a linear voltage: frequency characteristic in a voltage controlled oscillator which is employed to tune selectively to a range of frequencies in the incoming signal. The linearity of the oscillator is difficult to maintain over a wide frequency range, such as the VHF/UHF range, and that leads to considerable complexity in the circuitry. In consequence of this, known spectrum analysers are bulky and relatively expensive.

An article in the journal "Wireless World", vol. 86, no.1533, May 1980 edition points out that a conventional spectrum analyser mixes the input signal to be analysed with a much higher frequency signal from a variable local oscillator, the higher frequency signal being swept over a frequency range equal to the frequency range of the input signal (this is similar to the tuning arrangement of a superheterodyne radio receiver). The resulting mixed signal is passed through a complex and expensive narrow band pass filter to a linear or logarithmic detector whose output drives the vertical axis of an oscilloscope display, the horizontal axis being driven from the local oscillator. The article then attempts to provide a low cost audio spectrum analyser, capable of analysing a relatively narrow band width without the expensive bandpass filter. In this proposal, instead of sweeping over a higher range of frequencies, the tuneable local oscillator sweeps over the same range of frequencies as the input signal, in the manner of a so-called "synchrodyne" (more correctly, a "homodyne") radio receiver. The resulting mixed product signal is then passed through an inexpensive low pass filter for direct driving of the vertical axis of the oscilloscope.

Unfortunately, the above proposal is unsuitable for commercialisation because it produces spurious responses at low frequencies, and requires the use of an oscilloscope, which in itself is a large, expensive piece of equipment requiring use by a suitably skilled person.

One prior art device is disclosed in Patent Abstracts of Japan, vol.7, no.220 (P-226)[1365], September 30,1983 (published patent specification JP-A-58113867). In this proposal, the input signal is mixed with the output of a swept local oscillator and passed to a detector as an intermediate frequency signal. At the same time, the output of the swept local oscillator is mixed with a high frequency signal from a oscillator whose frequency can varied by a manually adjustable control unit. The mixed signal is passed to a further detector as an intermediate frequency, the outputs of both detectors being passed to a video mixer for production of a composite video output for display. The display therefore shows any coincidence between the manually adjustable oscillator and the input signal, the actual frequency of the coincidence being read off from a separate frequency display showing the frequency setting of the control unit. Hence, this is a device for measuring selected specific frequencies, rather than a frequency analyser as such, which should display absolute values over a range of frequencies.

In one of its aspects an object of the present invention is to provide a relatively simple and cheap frequency analyser.

Accordingly, the invention provides a frequency spectrum analyser for evaluating the frequency content of an input electrical signal, comprising:
(a) heterodyne circuit means for outputting a mixed product signal by beating the input electrical signal with a first frequency signal,
(b) means for sweeping the first frequency signal over a predetermined range of frequencies,
(c) bandpass filter means for filtering the output of the heterodyne circuit means to obtain a component of the electrical signal within the predetermined range of frequencies, and
(d) signal magnitude evaluation means for evaluating the magnitude of the output of the bandpass filter means,

the analyser being characterised by
(e) signal generator means for outputting a signal comprising a series of regularly spaced frequencies,
(f) mixer means for beating the first frequency signal with the output of the signal generator means,
(g) coincidence detector means connected to the mixer means for outputting a frequency interval signal whenever the frequency of the first frequency signal coincides with one of the regularly spaced frequency signals from said signal generator generator means, thereby to mark intervals in the frequency sweep of the first frequency signal,
(h) means for receiving the frequency interval signals from the coincidence detector means and the output of the signal magnitude evaluation means and outputting a frequency spectrum signal whose magnitudes represent a spectrum-divided sequence of components of the input electrical signal in frequency steps determined by said signal generator.

The invention further provides an electrical signal frequency analyser which comprises:
(i) means for reception of an input electrical signal comprising a plurality of different frequency components which are to be selectively detected,
(ii) means for generating a progressively changing frequency signal,
(iii) first mixing means for beating the input signal with said progressively changing frequency signal to produce a mixed product signal,
(iv) bandpass filter means to obtain from said mixed product signal a signal component within a predetermined range of frequencies, and
(v) signal magnitude evaluation means for evaluating the magnitude of the mixed and filtered signal component,

said frequency analyser being characterised by
(vi) signal generator means for generating a series of spaced frequency signals,
(vii) second mixing means for beating said spaced frequency signals with said progressively changing frequency signal,
(viii) coincidence detecting means for producing an output upon coincidence of the instantaneous frequency of said progressively changing frequency signal with any of the specific frequencies of said spaced frequency signals,
(ix) control means for producing, from said coincidence detecting means output, a series of frequency interval signals, and
(x) means for outputting, in accordance with said frequency interval signals, the signal magnitudes evaluated in the signal strength detector means,

whereby the output signal magnitudes represent a spectrum-divided sequence of components of the input electrical signal in frequency steps determined by said coincidence detecting means.

The bandpass filter means may comprise
(i) homodyne circuit means for beating said mixed product signal with a predetermined frequency signal equal to the centre frequency of the mixed product signal, and
(ii) low pass filter means for filtering the output of the homodyne circuit means to produce an output of limited bandwidth for evaluation by said signal magnitude evaluation means,

said signal magnitude evaluation means being adapted to output a measure of the integrated signal level of the low pass filtered signal over a bandwidth equal to twice the limit of the cut-off frequency of the low-pass filter means.

The signal generator means generates a comb spectrum and produces pulses from that spectrum containing the fundamental comb spectrum frequency and a series of harmonics thereof at said spaced frequencies.

Preferably, the analyser further comprises data processing means comprising
memory means for storing said signal magnitudes, as evaluated at successive of said frequency intervals, at respective addresses in said memory means corresponding to said frequency steps,
write means for writing said signal magnitudes to their respective addresses by reference to said frequency interval signals,
read means for reading out the stored data sequentially from the addresses in the memory means, and
means for generating a video signal representing the magnitude of the data read-outs with reference to said frequency intervals.

In a complementary aspect, the invention provides a method of analysing the frequency spectrum of an input electrical signal, comprising the steps of
(a) beating the input electrical signal with a first frequency signal which is swept over a predetermined range of frequencies, and
(b) filtering the signal resulting from step (a) to obtain a component of the electrical signal within the predetermined range of frequencies,
(c) evaluating the magnitude of the signal resulting from step (b),

the method being characterised by
(d) beating the first frequency signal with a signal comprising a series of regularly spaced frequencies,
(e) producing a frequency interval signal whenever the frequency of the first frequency signal coincides with one of the regularly spaced frequencies, thereby to mark intervals in the frequency sweep of the first frequency signal, and
(f) outputting a frequency spectrum signal whose magnitudes represent a spectrum-divided sequence of components of the input electrical signal in frequency steps determined by said spaced frequency signal.

Further understanding of the scope of the invention will be obtained from a perusal of the appended claims.

By way of example, the invention will be described in more detail with reference to the accompanying schematic drawings, in which:-
Fig. 1 shows in block form a spectrum analysis circuit for a radio frequency signal,
Fig. 2 shows in block form data processing means for producing a two-dimensional data display, in particular for use in conjunction with the circuit of Fig. 1, and
Fig. 3 illustrates a signal detector that can be used in a modification of the circuit in Fig. 1.

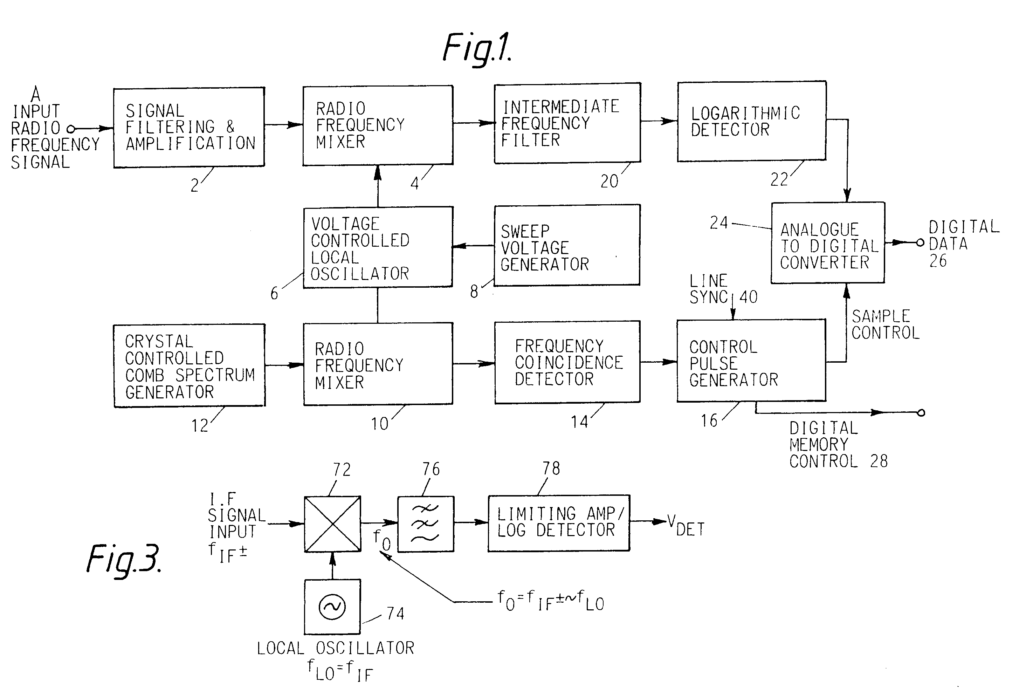

In Fig. 1 there is illustrated in block form a circuit that receives a radio signal containing a spectrum of frequencies and that functions to provide output indicating the signal strength at specific frequency values. The circuit includes means for sweeping a frequency range and is thus able to extract the data for a frequency analysis of the incoming signal.

From an input A, the incoming signal is received in a filtering and amplification unit 2 which provides an amplified form of the signal in the frequency range under investigation. This is input into a radio frequency mixer 4 having a second input of predetermined frequency from a local oscillator 6. The units mentioned so far can be essentially of conventional form and, indeed, operate in the manner of known superhet radio receiving circuits to provide an intermediate frequency signal by beating the radio frequency signal with that from the local oscillator.

In the present instance, however, the local oscillator 6 is a voltage-controlled unit and its output frequency is regulated by a sweep voltage generator 8, which may be simply a voltage ramp generator. The intermediate frequency signal output from the mixer 4 therefore corresponds to a range of input radio frequencies in dependence upon the change in the local oscillator frequency with the voltage ramp.

The local oscillator 6 has a further output to a second radio frequency mixer 10 and a crystal-controlled comb spectrum generator 12 provides a second signal to mix with this. The comb spectrum generator directly couples a pulsed signal, with a sharp spike waveform at intervals of, eg. 1MHz,into the mixer 10. Because of the waveform, each pulse appears as a mixture of the fundamental 1MHz frequency and all its harmonics. If the frequency range of the local oscillator 6 under the control of the voltage ramp is, for example, some 1-1200MHz, when beat with the comb spectrum generator pulses in the second mixer 10 a distinctive output will be obtained from the second mixer at each incremental 1MHz value of the local oscillator frequency as that frequency coincides with a specific harmonic, or the fundamental, in the comb spectrum pulses. The second mixer 10 outputs to a frequency coincidence detector 14 which identifies these points of coincidence and a control pulse generator 16 is actuated accordingly. The control pulses from the generator 16 thereby mark each 1MHz interval in the frequency sweep of the local oscillator 6.

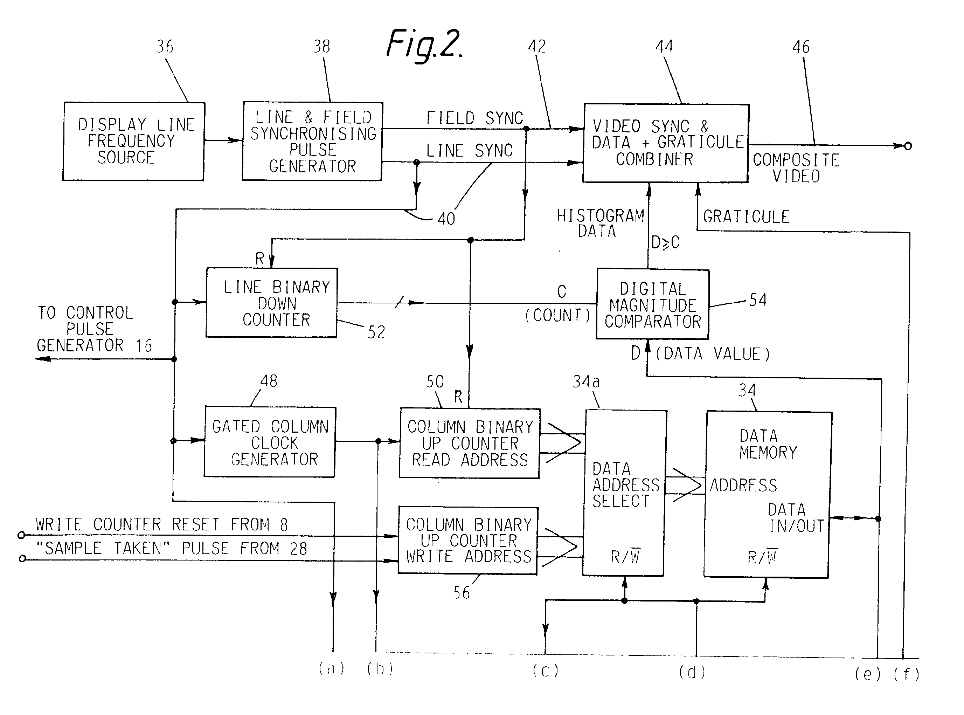

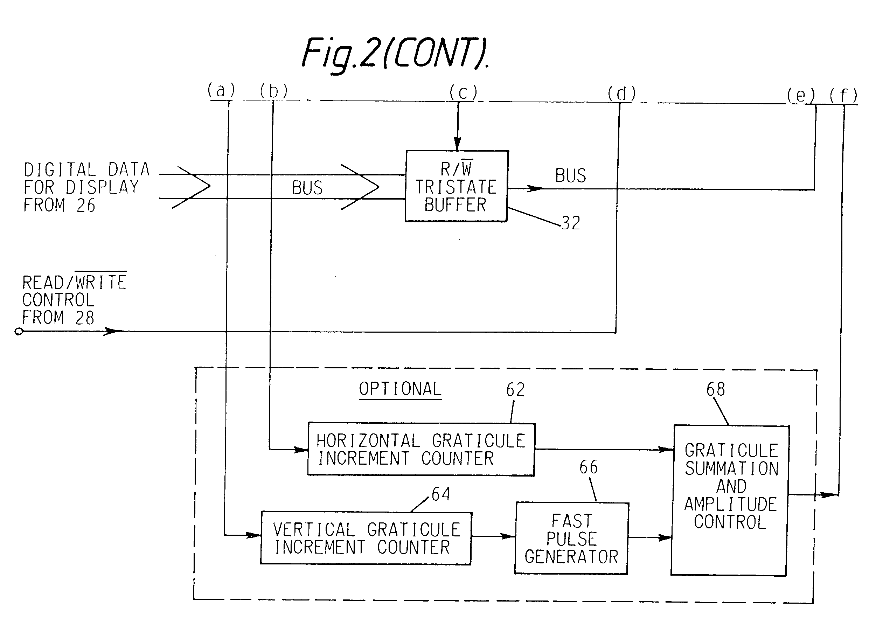

In the circuit shown in Fig. 1 the output from the first radio frequency mixer 4 is filtered and amplified in an intermediate frequency filter 20 to obtain the associated tuned frequency signal component from the input signal and this is measured in a logarithmic detector 22. For convenience of processing, the detector signal is digitised in an analogue to digital converter 24 which is outputted and cleared with each control pulse from the generator 16. The outputs from the converter 24 are a series of digital words each giving the signal strength of a specific frequency increment counted off by the comb spectrum. A spectrum analysis may therefore be presented by using the converter outputs through 26 and the control pulses of the generator 16 through 28 as the co-ordinates of a two-dimensional read-out. If required for the purpose of the read-out, as in the example to be described with reference to Fig. 2, a synchronising pulse input 40 can be applied to the generator 16 to time the control pulses.

The incremental frequency values, it should be noted, are determined fundamentally by the crystal of the comb generator. The sub-division of the frequency spectrum thus occurs independently of the linearity or otherwise of the ramp from the sweep voltage generator. The reading of the converter 24 by the control pulses generated from the comb spectrum automatically identifies the detected signal strengths with their frequency in the spectrum scanned.

Many of the circuits indicated in Fig. 1 may themselves be of conventional form. The frequency coincidence detector 14 and the logarithmic detector 22 can employ SL6652 or SL6654 IC's from Plessey Semiconductors and the comb spectrum generator 12 can employ an MSF-8685 IC from Avantek.

The apparatus of Fig. 1 may be employed for the analysis of many different types of radio frequency signals for a great variety of purposes. The monitoring of radio instrumentation is one example; others are the analysis of television and radio signals, the detection of interference signals and the measurement of circuit and aerial parameters, including the orientation of aerials.

The spectrum analysis data can be processed and presented in a variety of ways, depending on the purpose for which it has been produced. As one example, use is made of the display data processor illustrated in Fig. 2 by means of which the data is displayed in the form of a histogram on a video screen.

In Fig. 2, the circuit has a data input from 26 (Fig. 1) for the digital magnitudes of the individual columns of the histogram display and a control input from 28 (Fig. 1) for a control signal for assigning the digital magnitudes to their respective columns. The data inputs, which may consist of a series of 8-bit words, are input to a read-write buffer 32. The buffered data is read from the buffer and written into a data memory 34 by the control signal pulses from 28 which also operate on an address select 34a for the memory so as to assign each data word to a specific column address in the memory.

The circuit also comprises a frequency source 36 which actuates a line and field synchronising pulse generator 38 for the display screen (not shown). The pulse generator has outputs 40,42 for a stream of line synchronisation pulses rastering the display screen and for field synchronisation pulses recycling the raster. These pulses control a video synchroniser 44 by means of which composite video signals are transmitted through line 46 to a standard video input. Alternatively, by use of a video modulator the data may be presented to a standard television receiver antenna input for display.

The line synchronisation pulses are also input to a gated column clock generator 48, which scans a first column up counter 50 with succeeding line pulses, and to a line down counter 52. The column up counter 50 forms a read address counter and is connected to the address select 34a of the data memory 34 to scan the column addresses in the memory. As a result, the memory outputs in sequence, to a digital magnitude comparator 54, the data words read into those addresses from the buffer 32 for the successive columns of the display.

The line down counter 52 under the control of the line synchronisation pulses also outputs to the comparator 54 which then provides an output whenever the column magnitude value is equal to or greater than the line countdown value. While the line down counter indicates a row of the display, the addresses of the data memory are scanned by the column up counter and an output signal is produced by the comparator at each point on that row of the grid at which the data magnitude for a specific column is equal to or greater than the row value indicated by the line counter. The scan is repeated as the counter 52 counts down the lines of the display, the field synchronisation line providing a resetting pulse for the two counters 50,52 at the end of a raster.

The scan of each line will therefore provide video outputs for those points along the line at which the column magnitude is at least equal to the line count-down value. In each column, once the magnitude value matches the count-down value, all lower line values will also be illuminated as the line scan continues down the screen. The raster thus presents the data input in the form of a histogram. It is similarly possible to produce the histogram in a negative form by illuminating higher line values instead of lower values.

It is significant to note that although the data is presented on the screen in two-dimensional form, the data memory need hold only a series of data words representing single-dimension data magnitudes. Accordingly it can be a very much smaller and simpler unit than a store that is required to hold data for each of the grid of pixcels that occupy the area of the display screen.

Successive frequency strength signals are generated at a substantially lower rate than are the line synchronisation pulses. The address select 34a is normally held in the read mode from which it is switched only when new data appears from the A-D convertor 24. The new data is received by the buffer 32 and can be written into the memory 34 during intervals between data read outputs. Because the scan display area has a line length smaller than the line scan of the video signal, write periods are available between successive line scans and can be initiated by the line synchronisation pulses.

For this purpose a second column-up counter 56 functions as a write address counter; it is incremented by a "sample taken" pulse from line 28 from the control pulse generator 16. The pulse is outputted from the generator 16 after the reading of a data sample into the buffer 32 is completed, when the next line synchronisation pulse appears from the synchronising pulse generator 38. Accordingly, on each line synchronisation pulse, the control pulse on line 28 operates the address select 34a to select the write address given by the incremented counter 56 and also sets the memory 34 to the write mode to receive the data value from the buffer 32 at the selected write address. On completion of the writing operation, the system returns again to the read mode for the data display.

At the end of the column scan by the write address counter 56, a reset pulse sets the counter to zero for the beginning of a further up-count. The reset pulse in this example may come for instance from the sweep voltage generator 8.

Although the apparatus has been described as giving a histogram display, it will be understood that the single-dimensional memory can also be employed for other forms of display - eg. a line graph would be produced if an output signal was produced only when the magnitude value was coincident with the line countdown value. The display screen itself can of course take a variety of forms; for a hand-portable form of the apparatus, for example, it may be appropriate to use a liquid crystal display unit such as are currently available commercially.

Fig. 2 also shows, as an optional addition, means for generating a graticule on the display screen to facilitate reading the data display. For this purpose the pulses of the column clock generator 48 can be employed directly to drive a horizontal graticule increment counter 62 which generates horizontally spaced lines of the graticule at intervals determined by the counter 62. The line synchronisation pulses from the line 40 are inputted to a vertical graticule increment counter 64 to actuate a fast pulse generator 66 at intervals determined by the counter 64, the generator output on each countdown generating a vertically spaced line of the screen. The actuating signals from the horizontal increment counter 62 and the vertical increment pulse generator 66 are taken through a graticule summation and amplitude control 68 to the video synchroniser 44 where they are combined with the video data display.

It will be understood that although the display data processor of Fig. 2 has been described in conjunction with the frequency spectrum analysing circuit of Fig. 1, it can be applied to the display of any type of data that can be read into the memory 34 in the manner described and can be used to generate the display in the manner of a histogram or line chart or any other two-dimensional display on a raster scan display device.

It should be understood that a modified version of the display data processor could be produced which would embody the same basic principle of comparison of memory contents with a screen line down-count to produce video data, but would realise it by implimenting the pixel/line/write counting, timing signal control and memory address selection logic in an electrically programable logic device (EPLD) instead of utilising discrete components, the device being driven from an external high speed clock. As part of a spectrum analyser, its control logic would preferably include an equivalent to the control pulse generator 16 of Figure 1, which the device would replace. Horizontal and vertical graticule drives could also easily be implimented in the device.

In the circuit of Figure 1, the desired signal is filtered from the output of the radio frequency mixer 4 by the intermediate frequency bandwidth filter 20 for input to the logarithmic detector 22. Such a configuration may demand circuitry of a high technical specification: if a 1MHz bandwidth is to be selected from an intermediate frequency of 50MHz, a filter 20 with a Q of 50 is required, and complex circuitry is required to give the logarithmic detector sufficient dynamic range at that intermediate frequency.

Figure 3 shows a preferred alternative to such a filter, comprising a further radio frequency mixer 72, local oscillator 74 and low pass filter 76, which gives an output to a logarithmic detector 78 designed for substantially lower frequencies than the logarithmic detector 22 in Figure 1. Thus elements 72, 74 and 76 are used as an intermediate frequency filter to replace filter 20 in Figure 1 and detector 78 also replaces detector 22. In this way it is possible to perform the required filtering in a way that is simpler and more economical overall than if a standard fast roll-off L-C or quartz crystal filter is used.

The three circuits 72,74,76 may be formed by sections of an SL6652 or SL6654 IC from Plessey Semiconductors. For an equivalent discrimination at the 50MHz intermediate frequency referred to above, the low pass filter 76 would have an upper cut-off frequency limit of 500KHz. The local oscillator 74 is operated at the centre frequency of the intermediate frequency signal from the first radio frequency mixer 4 so that two signals of similar frequency are input to the radio frequency mixer of Figure 3, which thereby acts as a homodyne demodulator. Such a unit can be regarded as a form of superheterodyne demodulator with an intermediate frequency extending down to low or zero frequency. In these conditions, the 1MHz bandwidth signal to be detected in the second radio frequency mixer output is now in the frequency range ± 500 KHz, i.e. the filter frequency response range above the local oscillator frequency and the mirror image of that range.

In a state of precise synchronism there is of course no AC output from the second mixer 72 but in practice this effect is smoothed by the limits of discrimination in the circuitry. Although an analysis of the filter output would show some drop in response at zero frequency, this effect would be swamped by the response over the filter band unless an excessively low maximum pass frequency were set.

For efficient operation of the circuit of Figure 3, the input signal requires to be band-limited to ensure the suppression of frequencies that are harmonics of the frequency of the local oscillator 74, but the oscillator can be swept over almost an octave subject to that condition. A tuneable radio frequency logarithmic detector circuit such as that shown in Figure 3 can be used, however, for other purposes than a spectrum analyser if the required range of the local oscillator is not too great.

## Claims

1. A frequency spectrum analyser for evaluating the frequency content of an input electrical signal, comprising:
(a) heterodyne circuit means (4,6) for outputting a mixed product signal by beating the input electrical signal with a first frequency signal,
(b) means (8) for sweeping the first frequency signal over a predetermined range of frequencies,
(c) bandpass filter means (20) for filtering the output of the heterodyne circuit means (4,6) to obtain a component of the electrical signal within the predetermined range of frequencies, and
(d) signal magnitude evaluation means (22) for evaluating the magnitude of the output of the bandpass filter means (20),
the analyser being characterised by
(e) signal generator means (12) for outputting a signal comprising a series of regularly spaced frequencies,
(f) mixer means (10) for beating the first frequency signal with the output of the signal generator means (12),
(g) coincidence detector means (14,16) connected to the mixer means (10) for outputting a frequency interval signal whenever the frequency of the first frequency signal coincides with one of the regularly spaced frequency signals from said signal generator means (12), thereby to mark intervals in the frequency sweep of the first frequency signal,
(h) means (24) for receiving the frequency interval signals from the coincidence detector means (14,16) and the output of the signal magnitude evaluation means (22) and outputting a frequency spectrum signal (26) whose magnitudes represent a spectrum-divided sequence of components of the input electrical signal in frequency steps determined by said signal generator.

2. An electrical signal frequency analyser comprising
(i) means (A,2) for reception of an input electrical signal comprising a plurality of different frequency components which are to be selectively detected,
(ii) means (6,8) for generating a progressively changing frequency signal,
(iii) first mixing means (4) for beating the input signal with said progressively changing frequency signal to produce a mixed product signal,
(iv) bandpass filter means (20) to obtain from said mixed product signal a signal component within a predetermined range of frequencies, and
(v) signal magnitude evaluation means (22) for evaluating the magnitude of the mixed and filtered signal component,
said frequency analyser being characterised by
(vi) signal generator means (12) for generating a series of spaced frequency signals,
(vii) second mixing means (10) for beating said spaced frequency signals with said progressively changing frequency signal,
(viii) coincidence detecting means (14) for producing an output upon coincidence of the instantaneous frequency of said progressively changing frequency signal with any of the specific frequencies of said spaced frequency signals,
(ix) control means (16) for producing, from said coincidence detecting means output, a series of frequency interval signals, and
(x) means (24) for outputting, in accordance with said frequency interval signals, the signal magnitudes evaluated in the signal strength detector means (22),
whereby the output signal magnitudes represent a spectrum-divided sequence of components of the input electrical signal in frequency steps determined by said coincidence detecting means (14).

3. An analyser according to claim 2 characterised in that the output frequency of said means (6, 8) for generating said progressively changing frequency signal is regulated by a sweep voltage generator (8).

4. An analyser according to claim 3 characterised in that the sweep voltage generator (8) is a ramp generator.

5. An analyser according to any preceding claim, further characterised in that the bandpass filter means comprises
(i) homodyne circuit means for beating said mixed product signal with a predetermined frequency signal equal to the centre frequency of the mixed product signal, and
(ii) low pass filter means (76) for filtering the output of the homodyne circuit means to produce an output of limited bandwidth for evaluation by said signal magnitude evaluation means (78),
said signal magnitude evaluation means (78) being adapted to output a measure of the integrated signal level of the low pass filtered signal over a bandwidth equal to twice the limit of the cut-off frequency of the low-pass filter means (76).

6. An analyser according to any preceding claim, characterised in that said signal generator means (12) generates a comb spectrum and produces pulses from that spectrum containing the fundamental comb spectrum frequency and a series of harmonics thereof at said spaced frequencies.

7. An analyser according to any preceding claim, further characterised by data processing means comprising
memory means (34) for storing said signal magnitudes, as evaluated at successive of said frequency intervals, at respective addresses in said memory means corresponding to said frequency steps,
write means (56,34a) for writing said signal magnitudes to their respective addresses by reference to said frequency interval signals (28),
read means (48,50,34a) for reading out the stored data sequentially from the addresses in the memory means (34), and
means (36-44,52,54) for generating a video signal (46) representing the magnitude of the data read-outs with reference to said frequency intervals.

8. A method of analysing the frequency spectrum of an input electrical signal, comprising the steps of
(a) beating the input electrical signal with a first frequency signal which is swept over a predetermined range of frequencies, and
(b) filtering the signal resulting from step (a) to obtain a component of the electrical signal within the predetermined range of frequencies,
(c) evaluating the magnitude of the signal resulting from step (b),
the method being characterised by
(d) beating the first frequency signal with a signal comprising a series of regularly spaced frequencies,
(e) producing a frequency interval signal whenever the frequency of the first frequency signal coincides with one of the regularly spaced frequencies, thereby to mark intervals in the frequency sweep of the first frequency signal, and
(f) outputting a frequency spectrum signal whose magnitudes represent a spectrum-divided sequence of components of the input electrical signal in frequency steps determined by said regularly spaced frequency signal.

9. A method according to the preceding claim, further characterised in that step (b) comprises the steps of
(i) beating the signal resulting from step (a) with a predetermined frequency signal equal to the centre frequency of the signal resulting from step (a), and
(ii) low pass filtering the signal resulting from step (i) to produce a signal of limited bandwidth for evaluation in step (c).

10. A method according to claim 8 or claim 9, further characterised by data processing steps comprising
storing said signal magnitudes, as evaluated at successive of said frequency intervals, in memory means (34) at respective addresses therein corresponding to said frequency intervals,
writing said signal magnitudes to their respective addresses by reference to said frequency interval signals (28),
reading out the stored data sequentially from the addresses in the memory means (34), and
generating a video signal (46) representing the magnitude of the data read-outs with reference to said frequency intervals.

## Patentansprüche

1. Frequenzspektrum-Analysator zur Auswertung des Frequenzgehaltes eines elektrischen Eingangssignals mit den folgenden Merkmalen:
(a) eine heterodyne Schaltung (4, 6) zur Ausgabe eines gemischten Produktsignals durch Überlagerung des elektrischen Eingangssignals mit einem ersten Frequenzsignal,
(b) Mittel (8) zum Wobbeln des ersten Frequenzsignals über einen vorbestimmten Bereich von Frequenzen,
(c) ein Bandpaßfilter (20), um den Ausgang der heterodynen Schaltung (4, 6) zu filtern und eine Komponente des elektrischen Signals innerhalb des vorbestimmten Bereiches von Frequenzen zu erhalten, und
(d) eine Auswerterstufe (22) für die Signalgröße, um die Größe des Ausgangs des Bandpaßfilters (20) zu berechnen,
wobei der Analysator durch die folgenden Merkmale gekennzeichnet ist:
(e) ein Signalgenerator (12) liefert einen Signalausgang, der aus einer Reihe von im regelmäßigen Abstand zueinander liegenden Frequenzen besteht,
(f) eine Mischstufe (10) überlagert das erste Frequenzsignal mit dem Ausgang des Signalgenerators (12),
(g) ein Koinzidenzdetektor (14, 16) ist mit der Mischstufe (10) verbunden, um ein Frequenzintervallsignal immer dann zu liefern, wenn die Frequenz des ersten Frequenzsignales mit einem der im regelmäßigen Abstand angeordneten Frequenzsignale des Signalgenerators (12) zusammenfällt, wodurch Intervalle in der Frequenzwobbelung des ersten Frequenzsignals markiert werden,
(h) Mittel (24) zum Empfang der Frequenzintervallsignale vom Koinzidenzdetektor (14, 16) und dem Ausgang der Signalgrößen-Berechnungsstufe (22) und zur Ausgabe eines Frequenzspektrumsignals (26), dessen Größe eine durch das Spektrum dividierte Folge von Komponenten des elektrischen Eingangssignals in Frequenzstufen definiert, die durch den Signalgenerator bestimmt werden.

2. Elektrischer Signalfrequenz-Analysator mit den folgenden Merkmalen:
(i) Mittel (A, 2) zum Empfang eines elektrischen Eingangssignals, das aus mehreren unterschiedlichen Frequenzkomponenten besteht, die selektiv detektiert werden sollen,
(ii) Mittel (6, 8) zur Erzeugung eines sich progressiv ändernden Frequenzsignals,
(iii) eine erste Mischstufe (4), um das Eingangssignal mit dem sich progressiv ändernden Frequenzsignal zu überlagern und ein Mischproduktensignal zu erzeugen,
(iv) ein Bandpaßfilter (20), das von dem Mischproduktensignal eine Signalkomponente innerhalb eines vorbestimmten Frequenzbereiches erlangt, und
(v) eine Auswerterstufe (22) für die Signalgröße, um die Größe der gemischten und gefilterten Signalkomponente abzuschätzen,
wobei der Frequenzanalysator gekennzeichnet ist durch:
(vi) einen Signalgenerator (12) zur Erzeugung einer Reihe von im Abstand zueinander liegenden Frequenzsignalen,
(vii) eine zweite Mischstufe (10) zur Überlagerung der im Abstand zueinander liegenden Frequenzsignale mit dem sich progressiv ändernden Frequenzsignal,
(viii) einen Koinzidenzdetektor (14) zur Erzeugung eines Ausgangs bei Koinzidenz der augenblicklichen Frequenz des sich progressiv ändernden Frequenzsignals mit irgendeiner der spezifischen Frequenzen der im Abstand zueinander liegenden Frequenzsignale,
(ix) eine Steuereinrichtung (16), die aus dem Ausgang des Koinzidenzdetektors eine Reihe von Frequenzintervallsigalen liefert, und
(x) Mittel (24), um gemäß den Frequenzintervallsignalen die Signalgrößen zu liefern, die in dem Signalstärkendetektor (22) berechnet wurden,
wodurch die Ausgangssignalgrößen eine spektral geteilte Folge von Komponenten des elektrischen Eingangssignals in Frequenzstufen repräsentiert, die durch den Koinzidenzdetektor (14) bestimmt wurden.

3. Analysator nach Anspruch 2,
dadurch gekennzeichnet, daß die Ausgangsfrequenz der Mittel (6, 8) zur Erzeugung des sich progressiv ändernden Frequenzsignals durch einen Kippspannungsgenerator (8) geregelt wird.

4. Analysator nach Anspruch 3,
dadurch gekennzeichnet, daß der Kippspannungsgenerator (8) ein Sägezahngenerator ist.

5. Analysator nach einem der vorherhergehenden Ansprüche, dadurch gekennzeichnet, daß das Bandpaßfilter folgende Merkmale aufweist:
(i) eine homodyne Schaltung zur Überlagerung des gemischten Produktsignals mit einem vorbestimmten Frequenzsignal, welches gleich ist der Mittelfrequenz des gemischten Produktsignals, und
(ii) ein Tiefpaßfilter (76) zur Ausfilterung des Ausgangs der homodynen Schaltung und zur Erzeugung eines Ausgangs einer begrenzten Bandbreite zur Berechnung durch die Signalstärken-Auswertestufe (78),
wobei die Signalstärken-Auswertestufe (78) ein Maß des integrierten Signalpegels des im Tiefpaß gefilterten Signals über einer Bandbreite liefert, die doppelt so groß ist wie die Bandbreite der Grenzfrequenz des Tiefpaßfilters (76).

6. Analysator nach einem der vorhergehenden Ansprüche, dadurch gekennzeichnet, daß der Signalgenerator (12) ein kammartiges Spektrum erzeugt und Impulse von diesem Spektrum liefert, die die Grundfrequenz des kammartigen Spektrums und eine Reihe von Harmonischen hiervon bei den im Abstand zueinander liegenden Frequenzen enthalten.

7. Analysator nach einem der vorhergehenden Ansprüche, gekennzeichnet durch eine Datenverarbeitungsstufe, die folgende Elemente enthält:
einen Speicher (34) zur Speicherung der Signalgrössen, die bei aufeinanderfolgenden Frequenzintervallen berechnet wurden, und zwar an Adressen im Speicher, die den Frequenzstufen entsprechen,
eine Schreibstufe (56, 34a) zum Auftragen der Signalgrößen an ihren jeweiligen Adressen unter Bezugnahme auf die Frequenzintervallsignale (28),
eine Lesestufe (48, 50, 34a) zum aufeinanderfolgenden Auslesen der gespeicherten Daten aus den Adressen im Speicher (34) und
Mittel (36-44, 52, 54) zur Erzeugung eines Videosignals (46), welches die Größe der Datenauslesungen unter Bezugnahme auf die Frequenzintervalle repräsentieren.

8. Verfahren zur Analyse des Frequenzspektrums eines elektrischen Eingangssignals mit den folgenden Schritten:
(a) es wird das elektrische Eingangssignal mit einem ersten Frequenzsignal überlagert, welches über einen vorbestimmten Frequenzbereich gewobbelt wird, und
(b) es wird das Signal, welches von dem Schritt (a) herrührt, gefiltert, um eine Komponente des elektrischen Signals innerhalb des vorbestimmten Frequenzbereichs zu erhalten,
(c) es wird die Größe des vom Schritt (b) herrührenden Signals berechnet,
wobei das Verfahren durch die folgenden Schritte gekennzeichnet ist:
(d) es wird das erste Frequenzsignal mit einem Signal überlagert, welches eine Reihe von im gleichen Abstand zueinander angeordneten Frequenzen umfaßt,
(e) es wird ein Frequenzintervallsignal immer dann erzeugt, wenn die Frequenz des ersten Frequenzsignales mit einer der regulär im Abstand zueinander angeordneten Frequenzen zusammenfällt, wodurch die Intervalle in der Frequenzwobbelung des ersten Frequenzsignals markiert werden, und
(f) es wird ein Frequenzspektrumsignal geliefert, dessen Größe eine durch das Spektrum geteilte Folge von Komponenten des elektrischen Eingangssignals in Frequenzstufen ist, bestimmt durch die im regulären Abstand angeordneten Frequenzsignale.

9. Verfahren nach dem vorhergehenden Anspruch, weiter dadurch gekennzeichnet, daß der Schritt (b) die folgenden Teilschritte aufweist:
(i) es wird das Signal, welches von dem Schritt (a) herrührt, mit einem vorbestimmten Frequenzsignal überlagert, welches gleich ist der Mittelfrequenz des Signals, welches vom Schritt (a) herrührt, und
(ii) es wird das Signal, welches vom Schritt (i) herrührt, einer Tiefpaßfilterung unterworfen, um ein Signal begrenzter Bandbreite zur Berechnung im Schritt (c) zu erhalten.

10. Verfahren nach den Ansprüchen 8 oder 9,
welches weiter durch die folgenden Datenverarbeitungsschritte gekennzeichnet ist:
es werden die Signalgrößen, die bei den aufeinanderfolgenden Frequenzintervallen berechnet wurden, in einem Speicher (34) an entsprechenden Adressen gespeichert, die den Frequenzintervallen entsprechen,
es werden die Signalgrößen an ihren jeweiligen Adressen unter Bezugnahme auf die Frequenzintervallsignale (28) geschrieben,
es werden die gespeicherten Daten aufeinanderfolgend aus den Adressen im Speicher (34) ausgelesen und
es wird ein Videosignal (46) erzeugt, welches die Größe der Datenauslesungen in bezug auf die Frequenzintervalle repräsentiert.

## Revendications

1. Analyseur d'un spectre de fréquences pour évaluer le contenu de fréquence d'un signal électrique d'entrée, comprenant :
a) des moyens de circuit hétérodyne (4, 6) pour délivrer un signal de produit mélangé en faisant interférer le signal électrique d'entrée avec un premier signal de fréquence,
b) des moyens (8) pour moduler en fréquence le premier signal de fréquence sur un domaine de fréquences prédéterminé,
c) des moyens de filtre passe-bande (20) pour filtrer la sortie des moyens de circuit hétérodyiie (4, 6) pour obtenir un élément du signal électrique dans le domaine de fréquences prédéterminé, et
d) des moyens d'évaluation d'amplitude de signal (22) pour évaluer l'amplitude de la sortie des moyens de filtre passe-bande (20),
l'analyseur étant caractérisé par :
e) des moyens de générateur de signaux (12) pour délivrer un signal comprenant une série de fréquences espacées régulièrement,
f) des moyens de mélangeurs (10) pour faire interférer le premier signal de fréquence avec la sortie des moyens de générateur de signaux (12),
g) des moyens de détecteur de coïncidence (14, 16) connectés aux moyens de mélangeur (10) pour délivrer un signal d'intervalle de fréquences dès que la fréquence du premier signal de fréquence coïncide avec un des signaux de fréquences espacées régulièrement issus desdits moyens de générateur de signaux (12), pour ainsi marquer des intervalles dans la modulation de fréquence du premier signal de fréquence,
h) des moyens (24) pour recevoir les signaux d'intervalles de fréquences issus des moyens de détecteur de coïncidence (14, 16) et la sortie des moyens d'évaluation d'amplitude de signal (22) et pour délivrer un signal de spectre de fréquence (26) dont les amplitudes représentent une séquence spectralement divisée d'éléments du signal électrique d'entrée en pas de fréquence déterminés par ledit générateur de signaux.

2. Analyseur de fréquence d'un signal électrique comprenant :
i) des moyens (A, 2) pour recevoir un signal électrique d'entrée comprenant une pluralité de composantes de fréquences différentes qui doivent être détectées sélectivement,
ii) des moyens (6, 8) pour générer un signal de fréquence changeant progressivement,
iii) des premiers moyens de mélangeur (4) pour faire interférer le signal d'entrée avec ledit signal de fréquence changeant progressivement pour produire un signal de produit mélangé,
iv) des moyens de filtre prisse-bande (20) pour obtenir à partir dudit signal de produit mélangé un élément de signal dans un domaine de fréquences prédéteminé, et
v) des moyens d'évaluation d'amplitude de signal (22) pour évaluer l'amplitude de l'élément de signal mélangé et filtré,
ledit analyseur de fréquences étant caractérisé par :
vi) des moyens de générateur de signaux (12) pour générer une série de signaux de fréquences espacées,
vii) des seconds moyens de mélangeur (10) pour faire interférer lesdits signaux de fréquences espacées avec ledit signal de fréquence changeant progressivement,
viii) des moyens de détection de coïncidence (14) pour produire une sortie concernant la coïncidence de la fréquence instantanée dudit signal de fréquence changeant progressivement avec une quelconque des fréquences spécifiques desdits signaux de fréquences espacées,
ix) des moyens de commande (16) pour produire, à partir de ladite sortie des moyens de détection de coïncidence, une série de signaux d'intervalles de fréquence, et
x) des moyens (24) pour délivrer, en accord avec lesdits signaux d'intervalles de fréquence, les amplitudes du signal évaluées dans les moyens de détecteur d'intensité de signal (22),
les amplitudes du signal de sortie représentant une séquence spectralement divisée d'éléments du signal électrique d'entrée en pas de fréquence déterminés par lesdits moyens de détection de coïncidence (14).

3. Analyseur selon la revendication 2, caractérisé en ce que la fréquence de sortie desdits moyens (6, 8) pour générer ledit signal de fréquence changeant progressivement est régulé par un générateur de tension de balayage (8).

4. Analyseur selon la revendication 3, caractérisé en ce que le générateur de tension de balayage (8) est un générateur de rampe.

5. Analyseur selon l'une quelconque des revendications précédentes, caractérisé en outre en ce que les moyens de filtre passe-bande comprennent :
i) des moyens de circuit homodyne pour faire interférer ledit signal de produit mélangé avec un signal de fréquence prédéterminée égale à la fréquence centrale du signal de produit mélangé, et
ii) des moyens de filtre passe-bas (76) pour filtrer la sortie des moyens de circuit homodyne pour produire une sortie de bande passante limitée pour une évaluation par lesdits moyens d'évaluation d'amplitude de signal (78),
lesdits moyens d'évaluation d'amplitude de signal (78) étant adapté à produire une mesure du niveau de signal intégré du signal filtré passe-bas sur une bande passante égale à deux fois la limite de la fréquence de coupure des moyens de filtre passe-bas (76).

6. Analyseur selon l'une quelconque des revendications précédentes, caractérisé en ce que lesdits moyens de générateur de signaux (12) génèrent un spectre peigne en produisant des pulsations de ce spectre contenant la fréquence de spectre peigne fondamentale et une série d'harmoniques de celle-ci auxdites fréquence espacées.

7. Analyseur selon l'une quelconque des revendications précédentes, caractérisé en outre par
des moyens de traitement de données comprenant des moyens de mémoire (34) pour stocker lesdites amplitudes de signal, telles qu'évaluées à des intervalles successifs desdits intervalles de fréquence, à des adresses respectives dans lesdits moyens de mémoire correspondant auxdits pas de fréquence,
des moyens d'écriture (56, 34a) pour écrire lesdites amplitudes de signal dans leurs adresses respectives en référence auxdits signaux d'intervalles de fréquence (28),
des moyens de lecture (48, 50, 34a) pour sortir de manière séquentielle les données stockées des adresses dans les moyens de mémoire (34), et
des moyens (36-44, 52, 54) pour générer un signal vidéo (46) représentant l'amplitude des données sorties en référence auxdits intervalles de fréquence.

8. Procédé d'analyse du spectre de fréquence d'un signal électrique d'entrée, comprenant les étapes de
a) faire interférer le signal électrique d'entrée avec un premier signal de fréquence qui est modulé en fréquence sur un domaine de fréquences prédéterminée, et
b) filtrer le signal résultant de l'étape a) pour obtenir un élément du signal électrique dans le domaine de fréquences prédéterminé,
c) évaluer l'amplitude du signal résultant de l'étape b),
le procédé étant caractérisé par
d) faire interférer le premier signal de fréquences avec un signal comprenant une série de fréquences régulièrement espacées,
e) produire un signal d'intervalles de fréquences dès lors que la fréquence du premier signal de fréquence coïncide avec l'une des fréquences régulièrement espacées, pour ainsi marquer des intervalles dans la modulation de fréquence du premier signal de fréquences, et
f) délivrer un signal de spectre de fréquences dont les amplitudes représentent une séquence spectralement divisée d'éléments du signal électrique d'entrée en pas de fréquence déterminé par ledit signal de fréquences régulièrement espacées.

9. Procédé selon la revendication 8, caractérisé en outre en ce que l'étape b) comprend les étapes de :
i) faire interférer le signal résultant de l'étape a) avec un signal de fréquence prédéteminée égale à la fréquence centrale du signal résultant de l'étape a), et
ii) filtrer passe-bas le signal résultant de l'étape i) pour produire un signal de bande-passante limitée pour une évaluation dans l'étape c).

10. Procédé selon la revendication 8 ou la revendication 9, caractérisé en outre par des étapes de traitement de données comprenant de
stocker lesdites amplitudes de signal, telles qu'évalués à des intervalles successifs desdits intervalles de fréquence, dans des moyens de mémoire (34) à des adresses respectives correspondant auxdits intervalles de fréquence,
écrire lesdites amplitudes de signal dans leur addresses respectives en référence auxdits signaux d'intervalle de fréquences (28),
sortir de manière séquentielle les données stockées des adresses dans les moyens de mémoire (34), et générer un signal vidéo (46) représentant l'amplitude des données sorties en référence auxdits intervalles de fréquence.
